# EUROPEAN PATENT APPLICATION

(11) **EP 2 216 850 A1**
(43) Date of publication of application: **11.08.2010**
(21) Application number: 08853541.4
(22) Date of filing: 21.11.2008
(51) Int. Cl.: H01M 14/00, H01L 31/04, H01M 2/22, H01M 2/26

(54) **ELECTRODE SUBSTRATE FOR PHOTOELECTRIC CONVERSION ELEMENT**

(30) Priority: 28.11.2007 JP 2007307813
(71) Applicant: Fujikura, Ltd., Tokyo 135-8512 (JP)
(72) Inventor: MATSUI, Hiroshi, Sakura-shi Chiba 285-8550 (JP); OKADA, Kenichi, Sakura-shi Chiba 285-8550 (JP); KITAMURA, Takayuki, Sakura-shi Chiba 285-8550 (JP)
(74) Representative: Cabinet Plasseraud
(86) International application number: PCT/JP2008/071229
(87) International publication number: WO 2009/069551

(57) **Abstract**

ELECTRODE SUBSTRATE FOR PHOTOELECTRIC CONVERSION ELEMENT

An electrode substrate for a photoelectric conversion element includes: current collecting wires; and a protective layer covering the current collecting wires, wherein the protective layer includes a first protective layer containing glass components and a second protective layer which is composed of an insulating resin layer and provided on the first protective layer.

## Description

### BACKGROUND OF THE INVENTION

### Field of the Invention

The present invention relates to an electrode substrate used for a photoelectric conversion element such as a dye-sensitized solar cell.
Priority is claimed on Japanese Patent Application No. 2007-307813, filed on November 28, 2007, the content of which is incorporated herein by reference.

### Description of the Related Art

For an electrode substrate used for a photoelectric conversion element such as a dye-sensitized solar cell, a transparent conductive layer formed on a surface of a transparent substrate has been used. When a large-area and high-output element (module) for practical use is to be manufactured, in order to suppress an increase in internal resistance caused by low conductivity of the transparent conductive substrate, there have been attempts such as forming current collecting wires to increase conductivity of the electrode substrate. For the current collecting wires, a material with high conductivity such as metal (for example, silver, copper, and the like) with, particularly, low resistance may be used. In addition, the property of being chemically, electrochemically (practically) inactive to an electrolyte solution (for example, an iodine electrolyte) used for the element is required. Therefore, applying an insulating layer or a transparent conductive layer to the metal wiring layer as a protective layer has been proposed (see Published Japanese Translation No. 2000-536805 of PCT International Publication, Japanese Unexamined Patent Application, First Publication No. 2004-220920, Japanese Unexamined Patent Application, First Publication No. 2004-146425, PCT International Publication No. WO2004/032274, Japanese Unexamined Patent Application, First Publication No. 2007-042366, and M. Spath, et al., Progress in Photovoltaics: Research and Applications, vol. 11, pp. 207-220, H15 (2003).).

### SUMMARY OF THE INVENTION

As a wire protective material, a transparent conductive metal oxide and the like has been considered. However, forming a dense layer composed of the oxide so as not to allow the electrolyte solution to permeate is difficult.
As the wire protective material, a resin type material has also been considered. However, since the resin has problems such as swelling, pinholes, and permeation of gas or a volatile solvent, there is a reliability problem when the resin is used alone. Particularly, when the wiring layer is a printed wiring formed of a silver paste, the wiring layer includes a sinter of silver particles and is therefore porous. Accordingly, the gas or vapor of the volatile solvent may easily pass through the pores. In a configuration in which the printed wiring is directly coated only with a resin overcoat, the solvent may permeate a thin portion of the resin layer, leak outside through an opening of the wiring layer (which necessarily has the opening due to the need for power collection), and then be exposed to the external air. Simultaneously, along the opposite path, moisture or the like in the external air may permeate the electrolyte solution through the printed wiring layer and the resin layer.

Here, the permeability rate of total gas is in proportion to a permeation area and is in inverse proportion to a permeation distance. Therefore, similarly to the surface of the wire protective layer, when there is a path extending over the entire solar cell with a wide surface area and a total thickness of tens of micrometers, this causes high leakage in the long term.
A sealing portion of the cell has a smaller permeation area and a longer permeation distance and thus a cell with a small area is not particularly affected by the aforementioned problem. However, the problem is a crucial factor for securing long-term reliability with increases in cell area thereby achieving further practical use of dye-sensitized solar cell.

Referring to "Progress in Photovoltaics: Research and Applications, vol. 11, pp. 207-220, H15 (2003), by M. Späth, et al.," glass substrates are disposed at both of upper and lower surfaces (window side and back side) of a wiring portion, and a wiring layer and an electrolyte solution layer are inserted between the two glass substrates. In this structure, since the glass substrate has a low penetration of gas or the like, there is no leakage in the thickness direction of the glass substrate, and a leakage path may be generated only in a transverse direction of the wiring along the surface of the glass substrate. Therefore, the structure can have a smaller permeation area and a longer permeation distance. However, since the glass substrates used for both of the surfaces as described above have no ductility and flexibility, there is a limitation to a method of manufacturing and assembling cells. In addition, due to a difference between coefficients of the thermal expansion of the glass substrate and the resin sealing portion, the cell may be subject to stress from a heat cycle.

In addition, since a resin generally has low thermal resistance, it is difficult to perform heating to remove contaminants adsorbed on the surfaces of oxide semiconductor nanoparticles that serve as an optical electrode of the dye-sensitized solar cell. Particularly, when a hardening resin is used, volatile components from the hardening resin may contaminate the nanoparticle surfaces.

When only a low-melting-point glass layer is used as the protective layer (that is, when the low-melting-point glass layer is exposed as an outermost layer), in some conditions, the electrolyte solution reacts with the low-melting-point glass and accordingly it may lose its ability to function as an electrolyte for the dye-sensitized solar cell. Therefore, in an aspect that some components in the electrolyte solution react with some components of the low-melting-point glass, developing a composition of the electrolyte solution excluding the components that may react with the low-melting-point glass can be considered. However, the technical hurdle is too high to achieve both the composition and the function of the electrolyte for the dye-sensitized solar cell.

As a practical wire protective material, low-melting-point glass or heat-resistant resin may be considered. By using a low-melting-point glass type material and controlling a material condition such as a coefficient of thermal expansion, a protective layer having excellent denseness, chemical resistance, and thermal resistance can be formed. However, the glass type material is relatively harder than the resin type material and may damage a surface of a counter electrode during an electrode stacking process. In addition, since the glass material is brittle, the protective layer may be easily broken by an impact.

On the other hand, the resin material is flexible and does not easily damage the surface of the counter electrode when compared with an inorganic material such as the low-melting-point glass. However, the resin material has lower thermal resistance and barrier properties to block moisture or the like than the low-melting-point glass. In addition, when the surface of the resin-type protective material is scratched by a foreign material or the like, it is more likely to be damaged when compared with the low-melting-point glass.

The invention is designed to solve the above-mentioned problems. An object of the invention is to provide an electrode substrate used for a photoelectric conversion element having a wire protective material which suppresses leakage (reduction) or deterioration of an electrolyte solution, has a dense and high enough wiring protection function, is not easily damaged, and does not easily damage the surface of a counter electrode.

To solve the above-mentioned problems, the invention provides an electrode substrate for a photoelectric conversion element including: current collecting wires; and a protective layer covering the current collecting wires, wherein the protective layer includes a first protective layer containing glass components and a second protective layer which is composed of an insulating resin layer and provided on the first protective layer.
The second protective layer may be composed of an insulating resin having thermal resistance at 250°C or higher.
The second protective layer may be composed of one or more kinds selected from the group consisting of a polyimide derivative, a silicone compound, a fluorine elastomer, and a fluorine resin.

In the electrode substrate for a photoelectric conversion element according to the invention, even when the porous printed wires are used as the current collecting wires, the permeation of the solvent or gas through the wiring layer and the protective layer can be prevented. In addition, the wire protective layer cannot be easily damaged by foreign materials or the like and does not easily damage the surface of the counter electrode. In addition, deterioration of the electrolyte by reaction between the electrolyte and the material of the protective layer can be prevented.

### BRIEF DESCRIPTION OF THE DRAWINGS

FIG. 1 is a sectional view illustrating an example of an electrode substrate for a photoelectric conversion element according to the invention.
FIG. 2 is a sectional view illustrating a step (first step) of manufacturing the electrode substrate for a photoelectric conversion element of FIG. 1.
FIG. 3 is a sectional view illustrating a step (second step) of manufacturing the electrode substrate for a photoelectric conversion element of FIG. 1.
FIG. 4 is a sectional view illustrating a step (third step) of manufacturing the electrode substrate for a photoelectric conversion element of FIG. 1.
FIG. 5 is a sectional view illustrating a step (fourth step) of manufacturing the electrode substrate for a photoelectric conversion element of FIG. 1.
FIG. 6 is a sectional view illustrating a step (fifth step) of manufacturing the electrode substrate for a photoelectric conversion element of FIG. 1.
FIG. 7 is a sectional view illustrating an example of a photoelectric conversion element having the electrode substrate for a photoelectric conversion element according to the invention.

### DESCRIPTION OF REFERENCE NUMERALS

- 10: ELECTRODE SUBSTRATE
- 11: SUBSTRATE
- 12: TRANSPARENT CONDUCTIVE LAYER
- 13: CURRENT COLLECTING WIRES
- 14: PROTECTIVE LAYER
- 14a: FIRST PROTECTIVE LAYER
- 14b: SECOND PROTECTIVE LAYER
- 15: POROUS OXIDE SEMICONDUCTOR LAYER IN WHICH DYES ARE ADSORBED
- 15A: POROUS OXIDE SEMICONDUCTOR LAYER (BEFORE ALLOWING ADSORPTION OF DYES)
- 20: DYE-SENSITIZED SOLAR CELL (PHOTOELECTRIC CONVERSION ELEMENT)
- 21: COUNTER ELECTRODE
- 22: ELECTROLYTE

### DETAILED DESCRIPTION OF THE INVENTION

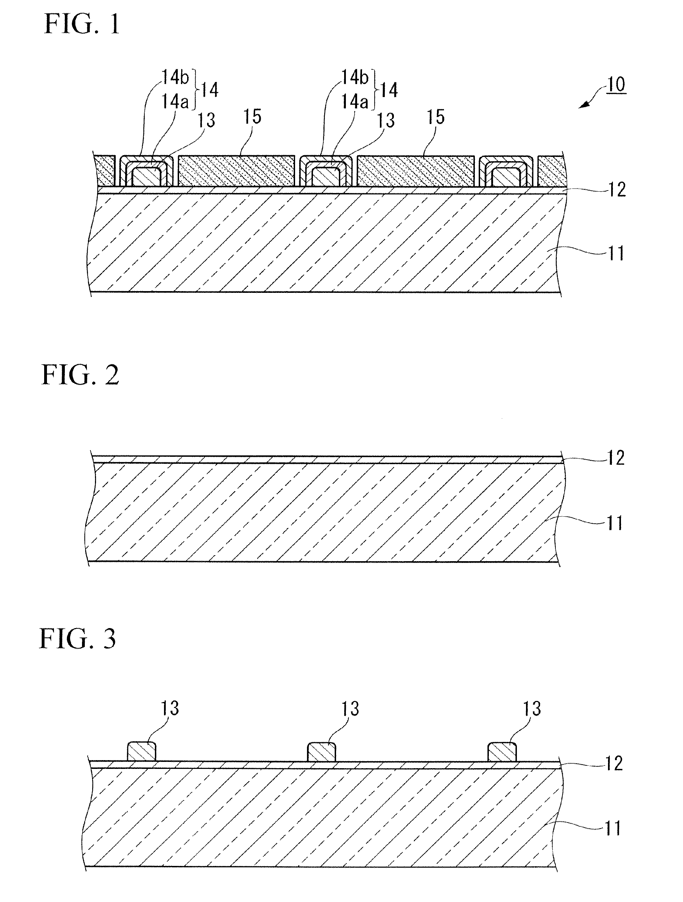

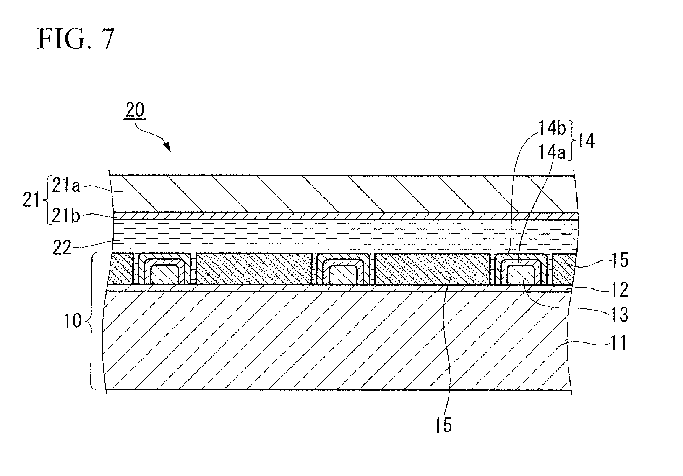

Hereinafter, best modes for the invention will be described with reference to the accompanying drawings. FIG. 1 is a sectional view illustrating an example of an electrode substrate for a photoelectric conversion element according to the invention. FIGS. 2 to 6 are sectional views illustrating steps of manufacturing the electrode substrate for a photoelectric conversion element of FIG 1. FIG. 7 is a sectional view illustrating an example of a photoelectric conversion element having the electrode substrate for a photoelectric conversion element according to the invention.

The electrode substrate 10 for a photoelectric conversion element according to an embodiment at least includes, as illustrated in FIG. 1, current collecting wires 13 and a protective layer 14 for covering current collecting wires 13, and the protective layer 14 at least includes a first protective layer 14a containing glass components and a second protective layer 14b which is composed of an insulating resin layer and provided on the first protective layer 14a. The electrode substrate 10 for a photoelectric conversion element illustrated in FIG. 1 includes a substrate 11, a transparent conductive layer 12 formed on the substrate 11, the current collecting wires 13 formed on the transparent conductive layer 12, the protective layer 14 for covering the current collecting wires 13, and a porous oxide semiconductor layer 15 formed on different portions of the transparent conductive layer 12 from portions thereof on which the current collecting wires 13 are formed.

As a material of the substrate 11, any material to practically form a transparent substrate such as glass, resin, ceramic, and the like may be used without limitation. Particularly, so as not to cause deformation, transformation, and the like of the substrate upon firing of the porous oxide semiconductor layer, a high-strain-point glass is preferable in terms of its excellent thermal resistance. However, soda-lime glass, clear glass, borosilicate glass, and the like may be suitably used.

A material of the transparent conductive layer 12 is not limited. For example, a conductive metal oxide such as tin-doped indium oxide (ITO), tin oxide (SnO₂), fluorine-doped tin oxide (FTO), and the like may be employed. As a method of forming the transparent conductive layer 12, a well-known method suitable for a corresponding material may be used. For example, there are sputtering, deposition, SPD, CVD, and the like. In addition, in consideration of light transparency and conductivity, the thickness of the transparent conductive layer 12 is generally in the range of 0.001 to 10 µm.

The current collecting wires 13 may be wires composed of metal such as gold, silver, copper, platinum, aluminum, nickel, titanium, and the like and formed in a pattern such as a grid pattern, a striped pattern, a comb pattern, and the like. So as not to significantly affect light transparency of the electrode substrate, the width of each wire may not be greater than 1,000 µm to be thin. The thickness (height) of each of the wires constituting the current collecting wires 13 is not particularly limited and may be in the range of 0.1 to 20 µm.

As a method of forming the current collecting wires 13, for example, there is a method in which a metal powder that serves as conductive particles is mixed with a binder such as glass fine particles into a paste form, the paste is applied to form a predetermined pattern by a printing technique such as screen printing, dispensing, metal mask printing, inkjet printing, or the like, and the conductive particles are fused by firing. The firing temperature is preferably 600°C or less, and more preferably, 550°C or less, when the substrate 11 is, for example, a glass substrate. In addition, forming methods such as sputtering, deposition, plating, and the like may be used. In terms of conductivity, the volume resistivity of the current collecting wires 13 is preferably equal to or less than 10⁻⁵ Ω·2cm. According to the invention, as described later, the protective layer includes the first protective layer containing glass components. Therefore, even when porous printed wires are used as the current collecting wires 13, permeation of a solvent through the wiring layer can be blocked.

The protective layer 14 at least includes the first protective layer 14a and the second protective layer 14b. The protective layer 14 may include other protective layers disposed under the first protective layer 14a (between the first protective layer 14a and the current collecting wires 13), between the first and second protective layers 14a and 14b, and above the second protective layer 14b.

The first protective layer 14a is composed of low-melting-point glass. The first protective layer 14a generally includes a lead-containing material such as lead borate. However, in point of environmental loads, a lead-free material is more preferable. For example, a low-melting-point glass material such as materials based on bismuth borosilicate/bismuth zinc borate, aluminophosphate/zinc phosphate, and borosilicate may be used. The first protective layer 14a may be formed by applying and firing a paste including as a main component low-melting-point glass composed of one or more kinds selected from the low-melting-point glass materials and as needed for controlling the coefficient of thermal expansion, viscosity, and the like, additives such as plasticizers, by screen printing, dispensing, or the like. The first protective layer 14a may be formed as a multilayer by using the same paste or different pastes.

The second protective layer 14b is composed of an insulating resin. As the insulating resin, heat-resistant resin may be used. For example, at least one selected from a polyimide derivative, a silicone compound, a fluorine elastomer, and a fluorine resin may be used singly or in combination by blending or laminating them. As the fluorine resin, one or more kinds selected from the group consisting of Teflon (registered trademark) type compounds such as polytetrafluoroethylene, a tetrafluoroethylene-perfluoroalkylvinylether copolymer, a tetrafluoroethylene-hexafluoropropylene copolymer, and the like may be used.

In the protective layer 14 including the two layers as described above, the first protective layer 14a composed of the glass component can suppress leakage (reduction) or deterioration of the electrolyte solution, and the second protective layer 14b provided as the overcoat can prevent the glass components of the first protective layer 14a from contacting to the electrolyte solution, thereby preventing the components in the glass and the components in the electrolyte solution from reacting with each other.

In addition, the first protective layer 14a blocks the penetration of gas. Therefore, in order to achieve only this advantage, heat-resistant resin or heat-resistant adhesive that can be fired at a high temperature is not needed. Instead, the second protective layer 14b may be formed by applying an adhesive with low thermal resistance or laminating a hot-melt adhesive as an overcoat. Particularly, when the second protective layer 14b is formed by laminating the hot-melt adhesive, poisoning of working electrodes is not severe. Therefore, in this case, good characteristics similar to those of the heat-resistant resin or the heat-resistant adhesive can be obtained.

According to the embodiment, the second protective layer 14b may be composed of an insulating resin having thermal resistance at 250°C or higher. More preferably, the second protective layer 14b may be composed of an insulating resin having thermal resistance at 300°C or higher. According to the invention, when the outer appearance of a resin is not deformed and weight reduction thereof is equal to or less than 30% during exposure for 1 to 2 hours at the set temperature, the temperature is determined as the thermal resistance temperature of the resin. Therefore, the insulating resin having thermal resistance at 250°C or higher means an insulating resin of which weight reduction during exposure at a temperature of 250°C for 1 to 2 hours is equal to or less than 30%, and the insulating resin having thermal resistance at 300°C or higher means an insulating resin of which weight reduction during exposure at a temperature of 300°C for 1 to 2 hours is equal to or less than 30%.

As the insulating resin having thermal resistance at 250°C or higher, one or more kinds of those having thermal resistance at 250°C or higher among the heat-resistant resins described above may be selected for use. In addition, as the insulating resin having thermal resistance at 300°C or higher, one or more kinds of those having thermal resistance at 300°C or higher among the insulating resins having thermal resistance at 250°C or higher may be selected for use. By using a resin material having high flexibility for the insulating resin layer, concerns about impact failure, fracture, and the like of the protective layer are lowered.

Since the insulating resin has thermal resistance at 250°C or higher, a step of heating the substrate 11 after firing the porous oxide semiconductor layer and before dye adsorption can be performed, thereby reducing contaminants adsorbed in the porous oxide semiconductor layer. As described above, to enable the protective layer to be subject to the heat treatment at 250°C or higher, the protective layer may be composed of the insulating resin having thermal resistance at 250°C or higher. More preferably, in order to enable heat treatment at 300°C or higher, the protective layer may be composed of the insulating resin having thermal resistance at 300°C or higher.

The low-melting-point glass layer and the heat-resistant resin layer may be formed by applying a single or plural kinds of the materials several times. In order to compensate for defects such as pinholes that may occur during printing and enhance denseness of the protective layer, the protective layer may be formed as a multilayer.

The thickness of the second protective layer 14b may be 1 µm or greater. When the second protective layer 14b is too thin, flexibility of the resin is degraded, and the surface of the counter electrode that the second protective layer 14b faces can be damaged. In addition, the resin layer itself can be damaged by incorporation of a foreign material or the like, or handling during manufacturing of the element.

The wire protective layer 14 may not need to be excessively thick, and the total thickness thereof is not greater than 100 µm.

The porous oxide semiconductor layer 15 is a porous layer obtained by firing oxide semiconductor nanoparticles (fine particles with an average size of 1 to 1,000 nm). As the oxide semiconductor, one or more kinds selected from the group consisting of titanium oxide (TiO₂), tin oxide (SnO₂), tungsten oxide (WO₃), zinc oxide (ZnO), niobium oxide (Nb₂O₅), and the like may be used. The thickness of the porous oxide semiconductor layer 15 may range, for example, from 0.5 to 50 µm.

As a method of forming the porous oxide semiconductor layer 15, for example, in addition to a method in which a desired additive is added to a dispersion liquid in which commercially available oxide semiconductor fine particles are dispersed in a dispersion medium, or to a colloid solution that can be adjusted by a sol-gel process, depending on applications, and the liquid is applied by a well-known method such as screen printing, inkjet printing, roll coating, doctor blade coating, spin coating, spray coating, and the like, there is an electrophoretic deposition for depositing oxide semiconductor fine particles immersed in a colloid liquid by electorphoresis on the substrate, a method of mixing a blowing agent with a colloid liquid or a dispersion liquid and applying and sintering the mixture so as to be porous, a method of adding polymer microbeads so as to be mixed and applied and removing the polymer microbeads to form pores by performing heat treatment or chemical treatment so as to be porous, and the like.

The sensitizing dyes to be carried on the porous oxide semiconductor layer 15 are not limited and may be suitably selected from a ruthenium complex or an iron complex with a ligand including a bipyridine structure, a terpyridine structure, and the like, a metal complex based on porphyrin or phthalocyanine, and an organic dye as derivative such as eosin, rhodamine, coumarin, and merocyanine, depending on applications and the material of the oxide semiconductor porous layer.

The electrode substrate for a photoelectric conversion element according to the embodiment may be manufactured in the following order.

First, as illustrated in FIG. 2, the transparent conductive layer 12 is formed on the substrate 11, and as illustrated in FIG. 3, the current collecting wires 13 are formed on the transparent conductive layer 12. In addition, the transparent conductive layer 12 may further be formed on the current collecting wires 13 to serve as a portion of the protective layer 14.

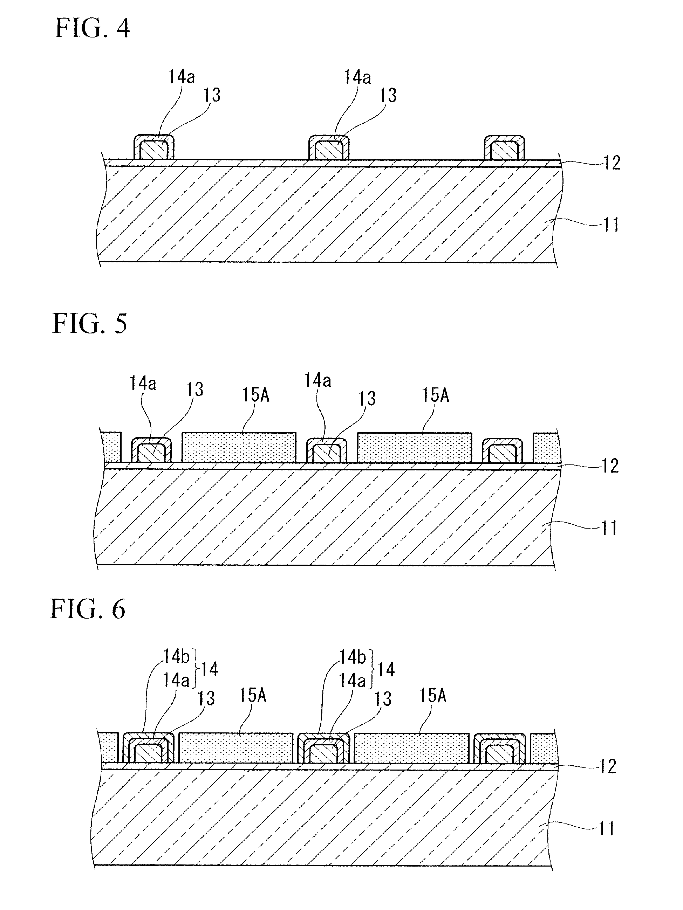

After forming the substrate 11 having the transparent conductive layer 12 and the current collecting wires 13 thereon as described above, as illustrated in FIG. 4, the first protective layer 14a containing glass components is formed to cover the current collecting wires 13.
Next, as illustrated in FIG. 5, the porous oxide semiconductor layer 15A is formed by a method of applying a paste of oxide semiconductor nanoparticles to different portions of the transparent conductive layer 12 from portions thereof on which the current collecting wires 13 and the first protective layer 14a are formed or the like.
Next, as illustrated in FIG. 6, the second protective layer 14b composed of the insulating resin layer is formed on the first protective layer 14a.

Here, in the examples illustrated in FIGS. 4 to 6, the following order is employed: forming and firing the current collecting wires 13, forming and firing the first protective layer 14a, forming and firing the porous oxide semiconductor layer 15A, and then forming the second protective layer 14b. However, the following orders (1) to (3) may also be employed:

(1) the order in which after forming and firing the current collecting wires 13, forming (only drying) the porous oxide semiconductor layer 15A, forming the first protective layer 14a, firing the first protective layer 14a and the porous oxide semiconductor layer 15A, and forming the second protective layer 14b are sequentially performed;
(2) the order in which after forming and firing the current collecting wires 13, forming and firing the porous oxide semiconductor layer 15A, forming and firing the first protective layer 14a, firing the first protective layer 14a and porous oxide semiconductor layer 15A, and forming the second protective layer 14b are sequentially performed; or
(3) the order in which after forming and firing the current collecting wires 13, forming (only drying) the first protective layer 14a, forming the porous oxide semiconductor layer 15A, firing the first protective layer 14a and porous oxide semiconductor layer 15A, and forming the second protective layer 14b are sequentially performed.
Here, the orders mentioned for forming the current collecting wires 13, the protective layer 14, and the porous oxide semiconductor layer 15A are only examples. For the invention, the order is not stated. In addition, it should be noted that in addition to the orders described, the order of each step can be appropriately selected. For example, forming the porous oxide semiconductor layer 15A may be performed before forming the current collecting wires 13. From among the current collecting wires 13, the protective layer 14, and the porous oxide semiconductor layer 15A, the second protective layer 14b may preferably be the last to be formed.

Next, by allowing adsorption of the dyes in the porous oxide semiconductor layer 15A, as illustrated in FIG. 1, the electrode substrate 10 having the porous oxide semiconductor layer 15 in which the dyes are adsorbed is completed. A method of forming the protective layer after the step of allowing adsorption of the dyes may be considered. However, in consideration of the contamination on the surface of the current collecting wires 13 and damage to the dyes during curing (heat treatment in case of a thermosetting resin, UV irradiation in case of a UV curing resin, and the like) of the insulating resin, allowing carrying of dyes after forming the protective layer 14 is preferable.

The electrode substrate for a photoelectric conversion element of the invention may be used as an optical electrode of a photoelectric conversion element such as a dye-sensitized solar cell. FIG. 7 illustrates an example of a configuration of the photoelectric conversion element 20 (dye-sensitized solar cell). The dye-sensitized solar cell may include the optical electrode having the electrode substrate 10 (electrode substrate 10) for a photoelectric conversion element according to the embodiment as a window electrode, a counter electrode 21 facing the optical electrode, and an electrolyte 22 included between the two electrodes.

As the counter electrode 21, although not particularly limited, specifically those in which a catalyst layer 21 b such as platinum, carbon, a conductive polymer, and the like is formed on a surface of a base material 21a such as a metal plate, a metal foil, and a glass plate may be exemplified. In order to enhance conductivity of the surface of the counter electrode, an additional conductive layer may be provided between the base material 2 1 a and the catalyst layer 2 1 b.

Particularly, when the counter electrode 21 is composed of a flexible substrate such as a metal foil and a resin film, the wiring layer and the protective layer included in the window electrode 10 (electrode substrate 10) are not joined to the counter electrode 21 (that is, there is an interval between the window electrode 10 and the counter electrode 21). Therefore, even when the window electrode 10 has a glass substrate as the substrate 11, the window electrode 10 is hardly affected by stress from heat cycle or the like. In addition, the counter electrode 21 bends along the window electrode 10 upon sealing, and accordingly the distance between the window electrode 10 and the counter electrode 21 is reduced, thereby enhancing electricity generation performance.

As the electrolyte 22, an organic solvent including a redox couple, a room-temperature molten salt (ionic liquid), and the like may be used. In addition, instead of an electrolyte solution, those in which an electrolyte solution is added with a suitable gelator (for example, a high-molecular gelator, a low-molecular gelator, various types of nanoparticles, carbon nanotubes, and the like) and quasi-solidified, that is, a so-called gel electrolyte may be used.
A method of providing the electrolyte 22 into the cell is not particularly limited. For example, when the electrolyte solution is used, there is a method in which the window electrode 10 and the counter electrode 21 are disposed to face each other and sealed by a resin or an adhesive or the like and the electrolyte solution is injected through a suitably provided injection hole. When the gel electrolyte is used, there is a method in which the gel electrolyte is applied on the window electrode 10 and the counter electrode 21 is attached thereto.

As the organic solvent, although not particularly limited, acetonitrile, methoxyacetonitril, propionitril, methoxypropionitril, propylene carbonate, diethyl carbonate, γ-butyrolactone, or the like is exemplified. As the room-temperature molten salt, room-temperature molten salt including a cation such as an imidazolium type cation, a pyrrolidinium type cation, a pyridinium type cation, and the like and an anion such as an iodide ion, a bis(trifluoromethylsulfonyl)imide anion, a dicyanamide anion, and a thiocyanic acid anion is exemplified.

As the redox couple contained in the electrolyte, although not particularly limited, pairs such as an iodine/iodide ion and a bromine/bromide ion may be added to obtain the redox couple. As a source of the iodide ion or the bromide ion, lithium salt, quaternary imidazolium salt, tetrabutylammonium salt, and the like, which contain the anion of the iodine ion or the bromide ion, may be used singly, or in combination. To the electrolyte, as needed, an additive such as 4-tert-butylpyridine, N-methylbenzimidazol, and guadinium salt may be added.

In the photoelectric conversion element according to the invention, the current collecting wires of the electrode substrate are provided with the protective layer without defects such as pinholes, so that the photoelectric conversion element can achieve excellent electricity generation performance.

### Examples

Now, the invention will be specifically described with Examples. The invention is not limited by Examples.

### 1. Experimental Example on Leakage Prevention Performance of Electrolyte

As shown in Table 1, cells having different wire protective layers and different electrolytes, according to Examples 1 and 2 and Comparative Examples 1 and 2 were manufactured. As a condition common to Examples 1 and 2 and Comparative Examples 1 and 2, a window electrode is the glass substrate having a transparent conductive layer at a surface, current collecting wires are composed of a printed circuit formed by screen-printing a silver paste, and a porous oxide semiconductor layer is composed of titania (titanium oxide) carrying dyes.

**Table 1**

| | Example 1 | Example 2 | Comparative Example 1 | Comparative Example 2 |
|---|---|---|---|---|
| Wire Protective Layer | Glass and Polyimide Layer | Glass and Polyimide Layer | Polyimide Layer Only | Polyimide Layer Only |
| Electrolutic Solution | Volatile Type | Ionic Liquid Type | Volatile Type | Ionic Liquid Type |

In Example 1, the cell was manufactured by using as the wire protective layer glass layer (the first protective layer) having polyimide layer thereon as an overcoat, and as the electrolyte a volatile type electrolyte solution.
In Example 2, the cell was manufactured by using as the wire protective layer a glass layer (the first protective layer) having a polyimide layer thereon as an overcoat, and as the electrolyte an ionic liquid-type electrolyte solution.
In Comparative Example 1, the cell was manufactured by using as the wire protective layer only a polyimide layer and as the electrolyte a volatile type electrolyte solution.
In Comparative Example 2, the cell was manufactured by using as the wire protective layer only a polyimide layer and as the electrolyte an ionic-liquid type electrolyte solution.

For evaluation of the cells of Examples 1 and 2 and Comparative Examples 1 and 2, change in cells after being kept for 50 hours at 85°C and 85%RH (relative humidity) was evaluated by observing change in the amount of electrolyte solution, occurrence of color change in the dye-sensitized titania electrode, and measuring the rate of change [(η0+Δη)/η0] of electricity generation performance. Here, in order to obtain the rate of change of electricity generation performance, an electricity generation efficiency before maintaining the condition which was set to η0 and an electricity generation efficiency after maintaining the condition which was set to η0+Δη) were measured, and the ratio therebetween is obtained as a percentage. The evaluation result is shown in Table 2.

**Table 2**

| | Reduction in Electrolytic solution | Color Change in Dye-setisttized Titania Electrode | The rate of Change of Electricity Generation Performance |
|---|---|---|---|
| Example 1 | hardly shown | No | 95% |
| Example 2 | hardly shown | No | 105% |
| Comparative Example 1 | 25wt% reduction | slight discoloration and color staining | 11% |
| Comparative Example 2 | hardly shown | significant discoloration is shown | 81% |

As shown in Table 2, in Examples 1 and 2, it can be seen that the reduction in the electrolyte solution had hardly occurred, and thus high solvent leakage-prevention performance could be obtained. In addition, there was no color change in the dye-sensitized titania electrode, the rate of change of electricity generation performance were 95% and 105% in Examples 1 and 2, respectively, changes in performance under heat and humidity conditions were very small, and thus high reliability could be achieved.

In Comparative Example 1, it can be seen that the amount of the electrolyte solution is reduced by about 25%, there was little color change in the dye-sensitized titania electrode, and the stain on a point at which the electrolyte solution is reduced and dried was shown. In addition, the rate of change of the electricity generation performance was 11 %, and performance degradation was significant.
In Comparative Example 2, although reduction in electrolyte solution was hardly shown, significant discoloration of the dye-sensitized titania electrode was observed, and it was assumed that moisture was incorporated into the electrolyte solution. In addition, the rate of change of the electricity generation performance was 81 %. Although the performance was not significantly deteriorated when compared with Comparative Example 1, it was thought that the incorporation of moisture into the ionic-liquid system electrolyte solution has degraded the function of the electrolyte.

### 2. Experimental Example on Scratch Prevention Performance of Counter Electrode and Window Electrode

### Glass Substrate

i) high-strain-point glass PD200 (Asahi glass Co. Ltd)
ii) commercially available FTO glass (Nihon sheet glass Co. Ltd)

### Wire Protective Material (I)

A) low-melting-point glass A: lead borate type (Fukuda metal foil & powder Co. Ltd)
B) low-melting-point glass B: zinc silicate phosphor type (Fukuda metal foil & powder Co. Ltd)
C) low-melting-point glass C: bismuth borate type (Fukuda metal foil & powder Co. Ltd)

### Wire protective Material (II)

Heat-resistant resin a) polyimide varnish (I. S. T), breaking elongation 5% or higher (about 65%), curing temperature Max 350°C to 400 °C
Heat-resistant resin b) silicon varnish (GE Toshiba silicon Co. Ltd), breaking elongation 5% or higher, curing temperature 300°C or less
Heat-resistant resin c) fluorine elastomer SIFEL (Shin-Etsu chemical Co. Ltd), breaking elongation 5% or higher (about 200%), curing temperature 300°C or less
Heat-resistant resin d) Teflon (registered trademark) coating material (Nippon fine coatings Inc), breaking elongation 5% or higher, treatment temperature 300°C or less
Heat-resistant resin e) UV curing resin (Threebond co. Ltd)

### <Manufacturing of Electrode Substrate>

In order to examine thermal resistance of the wire protective materials a) to d), each material was heated at 250°C for 1 hour, and the weight reduction and the appearance thereof were examined. For all of the materials, the weight reduction of each material was not greater than 30%, and the appearance thereof had no problem. Thermal resistance of the wire protective material d) was also examined as described above. Here, the weight reduction thereof was higher than 30%, and the outer appearance had problems.
Glass substrates (each of which is 140mm square and coated with an FTO film on the surface) i) and ii) were prepared, and a silver circuit was formed on the FTO film in a grid pattern by screen printing. In designing the shape of the circuit, the circuit width was set to 300 µm, and the film thickness was set to 10 µm. For printing, a silver paste with a volume resistivity after sintering of 3×10⁻⁶ Qcm was used. After printing, the silver paste was dried at 130°C, and the silver circuit was sintered at the maximum temperature of 510°C, thereby forming the circuit.

Next, the low-melting-point glass paste of the wire protective layer (I) was applied to overlap with the circuit formation portion and entirely cover the silver circuit, thereby forming the printing-coated film of glass. The design width of the first protective layer was set to 500 µm, and the first protective layer was applied by screen printing or dispensing while aligned with the silver circuit by using a CCD camera. After drying the printing-coated film at 130°C, on different portions of the FTO film of the electrode substrate from portions thereof on which the silver circuit and the protective layer were formed, a paste containing TiO₂ nanoparticles was applied by screen printing and dried. After drying them, the first protective layer (only an amount corresponding to a single application) and the porous oxide semiconductor layer were sintered at the maximum temperature of 500°C. In addition, in order to guarantee the thickness of the first protective layer, forming and sintering a printing-coated film of glass were performed several times on the layer that had been subjected to a single application, thereby forming the first protective layer.

In addition, the resin (the paste) of the heat-resistant resin of the wire protective material (II) was applied to entirely cover the first protective layer, and the resin film was treated at the maximum temperature of 300°C to 350°C. This was repeated several times as needed, thereby forming the second protective layer. The design width of the second protective layer was set to 800 µm, and the second protective layer was applied by screen printing or dispensing while aligned with the silver circuit by using a CCD camera.

The dye-sensitized solar cell was manufactured by using the electrode substrate manufactured as described above.
The electrode substrate was immersed in an acetonitrile/t-butanol solution of ruthenium bipyridine complex (N719 dye) for a day or more to carry the dyes and serve as the optical electrode. Here, for those requiring heating only at a temperature lower than 300°C during the formation of the second protective layer, heat treatment was performed at 350°C for 1 hour right before the carrying of the dyes.

As the counter electrode, a titanium (Ti) foil having a platinum (Pt) layer formed thereon by sputtering were used. In a circulation and purification type glove box filled with inert gas, an iodine electrolyte is deployed to be stacked on the optical electrode and face the counter electrode, and the periphery of the element was sealed by the UV curing resin. As the iodine electrolyte, the following A and B were used. In addition, M represents mol/L.

Electrolyte A; 0.5M 1, 2-dimethyl-3-propylimidazolium iodide and 0.05M iodine was dissolved in methoxyacetonitril, and an adequate amount of lithium iodide and 4-tert- butylpyridine was added thereto.

Electrolyte B; 1-hexyl-3-methyl imidazolium iodide and iodine were mixed at a molar ratio of 10:1, an adequate amount of N-methylbenzimidazol and thiocyanic acid guadinium was added thereto, and SiO₂ nanoparticles of 4 wt% were mixed therewith, followed by kneading into a quasi-solid.

The dye-sensitized solar cell manufactured as described above was evaluated as follows.

Evaluation 1: after checking the electricity generation characteristics, the element was dissembled, and areas around the portion of the surface of the counter electrode overlapping with the wire protective layer were observed using SEM. A case where there is no noticeable scratch on the observed portion was evaluated as "G", a case where the element with noticeable scratch is included was evaluated as "NG", and a case of significant scratch was evaluated as "B". For each condition, 5 evaluation samples were prepared.

Evaluation 2: in order to conduct a simulation of scratches caused by foreign materials, the surface of the wire protective layer of the manufactured electrode substrate was cut by a single-edged razor blade, and scratches extending to the metal wiring from the surface of the wire protective layer was detected.
A case where there is no scratch extending to the metal wiring was evaluated as "G", and a case where a scratch extending to the metal wiring occurs was evaluated as "B".

Evaluation 3: photoelectric conversion characteristics of the manufactured dye-sensitized solar cell element were examined. The condition for light irradiation was set to AM1. 5, 100 mW/cm². For each condition, 5 evaluation samples were used and measured, and an average (N=5) was calculated as the measurement result.

The evaluation results of Evaluations 1 to 3 are shown in Tables 3 to 5. In Tables 3 to 5, "substrate" represents a kind of the glass substrate used for the electrode substrate, "protective layer 1" represents a kind of the wire protective material I (low-melting-point glass) used for the electrode substrate, "protective layer 2" represents a kind of the wire protective material II (heat-resistant resin) used for the electrode substrate, "counter electrode scratch" represents the evaluation result of Evaluation 1, "own scratch" represents the evaluation result of the Evaluation 2, "conversion efficiency A" represents photoelectric conversion characteristics (%) measured in Evaluation 3 on the dye-sensitized solar cell element using the electrolyte A, and "conversion efficiency B" represents photoelectric conversion characteristics (%) measured in Evaluation 3 on the dye-sensitized solar cell element using the electrolyte B. In addition, "-" in "protective layer 1" and "protective layer 2" represents a case where the corresponding protective layer is omitted.

**Table 3**

| Number | 1-1 | 1-2 | 1-3 | 1-4 | 1-5 | 1-6 | 1-7 | 1-8 |
|---|---|---|---|---|---|---|---|---|
| Substrate | i) | i) | i) | i) | i) | i) | i) | i) |
| Protective Layer 1 | A | A | A | A | A | A | - | - |
| Protective Layer 2 | a | b | c | d | e | - | a | c |
| | | | | | | | | |
| Counter Electrode Scratch | G | G | G | G | G | NG | G | G |
| Scratch on itself (own scratch) | G | G | G | G | G | G | B | B |
| Conversion Efficiency A | 6 | 5.8 | 6 | 5.7 | 2 | - | - | - |
| Conversion Efficiency B | 3.8 | 3.8 | 3.9 | 3.8 | 1.3 | - | - | - |

**Table 4**

| Number | 2-1 | 2-2 | 2-3 | 2-4 | 2-5 | 2-6 |
|---|---|---|---|---|---|---|
| Substrate | i) | i) | i) | i) | i) | i) |
| Protective Layer 1 | B | B | C | C | B | C |
| Protective Layer 2 | a | c | b | d | - | - |
| | | | | | | |
| Counter Electrode Scratch | G | G | G | G | NG | NG |
| Own Scratch | G | G | G | G | G | G |
| Conversion Efficiency A | 5.7 | 5.9 | 5.7 | 5.7 | - | - |
| Conversion Efficiency B | 3.7 | 3.8 | 3.8 | 3.6 | - | - |

**Table 5**

| Number | 3-1 | 3-2 | 3-3 | 3-4 | 3-5 |
|---|---|---|---|---|---|
| Substrate | ii) | ii) | ii) | ii) | ii) |
| Protective Layer 1 | A | A | A | A | A |
| Protective Layer 2 | a | b | c | d | - |
| | | | | | |
| Counter Electrode | G | G | G | G | NG |
| Scratch | | | | | |
| Own Scratch | G | G | G | G | G |
| Conversion Efficiency A | 5.7 | 5.8 | 5.7 | 5.6 | - |
| Conversion Efficiency B | 3.6 | 3.6 | 3.7 | 3.6 | - |

From the measurement results, in 1-1 to 1-4, 2-1 to 2-4, and 3-1 to 3-4 according to Examples, counter electrode scratches and own scratches were not given, and good conversion efficiency was obtained. In 1-5 in which the resin e) with low thermal resistance was used for the protective layer 2, conversion efficiency was degraded. In 1-7 and 1-8 in which the protective layer 1 was not employed and only the protective layer 2 was used, there was a scratch extending to the metal wiring generated by the razor. In 1-6, 2-5, 2-6, and 3-5 in which the protective layer 2 was not employed and only the protective layer 1 was used, there were counter electrode scratches.

The invention can be used for the photoelectric conversion element such as the dye-sensitized solar cell.

## Claims

1. An electrode substrate for a photoelectric conversion element comprising:
current collecting wires; and
a protective layer covering the current collecting wires,
wherein the protective layer includes a first protective layer containing glass components and a second protective layer which is composed of an insulating resin layer and provided on the first protective layer.

2. The electrode substrate for a photoelectric conversion element according to claim 1, wherein the second protective layer is composed of an insulating resin having thermal resistance at 250°C or higher.

3. The electrode substrate for a photoelectric conversion element according to claim 1 or 2, wherein the second protective layer is composed of one or more kinds selected from the group consisting of a polyimide derivative, a silicone compound, a fluorine elastomer, and a fluorine resin.
